# EUROPÄISCHE PATENTSCHRIFT

(11) **EP 0 580 085 B1**
(45) Veröffentlichungstag und Bekanntmachung des Hinweises auf die Patenterteilung: **18.03.1998**
(21) Anmeldenummer: 93111417.7
(22) Anmeldetag: 16.07.1993
(51) Int. Cl.: G11C 7/00

(54) **Speicherbausteinanordnung**
Memory device component
Composant de dispositif de mémoire

(30) Priorität: 24.07.1992 DE 4224421
(43) Veröffentlichungstag der Anmeldung: 26.01.1994
(73) Patentinhaber: ALCATEL ALSTHOM COMPAGNIE GENERALE D'ELECTRICITE, 75008 Paris (FR)
(72) Erfinder: Schmidtke, Peter, D-70825 Korntal-Münchingen (DE)
(74) Vertreter: Brose, Gerhard, Dipl.-Ing.

(56) Entgegenhaltungen:
- EP-A- 0 310 173
- EP-A- 0 419 958
- EP-A- 0 454 218

## Beschreibung

Die Erfindung betrifft eine Speicherbausteinanordnung mit einem elektronischen Speicherbaustein, dessem Speicher ein Datenstrom zugeführt wird, und der eine Speicherlogik aufweist, welche die im Speicher abgespeicherten Bits des Datenstroms zu Zellen definierter Bit-Länge zusammenfaßt, die an einem Leseausgang des elektronischen Speicherbausteins abgreifbar sind, wobei die Speicherlogik des elektronischen Speicherbausteins für jede vollständige Zelle definierter Bit-Länge ein Zählimpuls-Speichersignal erzeugt, das einer Zähleinrichtung einer Füllstandsüberwachungsschaltung zugeführt wird, deren Zählerstand durch das von der Speicherlogik erzeugte Zählimpuls-Speichersignal inkrementiert wird.

Ein derartiger elektronischer Speicherbaustein ist bekannt. Er wird in ATM (Asynchronos Transfer Mode)-Kommunikationsanlagen eingesetzt. Nachteilig an den bekannten elektronischen Speicherbausteinen ist, daß keine exakte Überwachung des Füllstandes vorgesehen ist. Es sind zwar Speicherbausteine bekannt, die anzeigen, daß sie halb oder ganz gefüllt sind. Dies geschieht durch die Verwendung eines "Halb-Voll-Bits", welches die entsprechende Speicherbelegung anzeigt. Nachteilig an dieser Art der Überwachung ist aber, daß hierbei eine große Verzögerung des Datenstroms auftritt, da der Speicher des elektronischen Speicherbausteins erst halb voll laufen muß, bis zum ersten Mal eine Anzeige auftritt. Eine derartige Verzögerung ist insbesondere bei Kommunkationsnetzen sehr von Nachteil, da hierbei die maximal zulässige Verzögerungszeit der Daten vom Sender bis zum Empfänger nicht überschritten werden darf. Durch die bei der Übertragung benötigten Datenpuffer addieren sich aber die einzelnen Verzögerungszeiten, so daß die o.g. Überwachung des Füllstandes insbesondere beim Erzeugen von ATM-Zellen und beim Multiplexen der Datenströme zu nicht mehr tolerablen Verzögerungszeiten führt.

Um ein Überlaufen des Speichers zu verhindern, ist es bekannt, daß die Speicherkapazität des elektronischen Speicherbausteins in Abhängigkeit von der vorgesehenen Speicher-Auslesefrequenz derart hoch bemessen wird, daß auch bei der maximalen Baud-Zahl des zugeführten Datenstroms immer genügend Speicherkapazität zur Verfügung steht. Diese Vorgehensweise bringt aber in nachteiliger Art und Weise eine Überdimensionierung des Speichers mit sich, welche die Herstellung eines derartigen elektronischen Speicherbausteins unnötigerweise verteuert.

Zur Vermeidung dieser Nachteile stellt sich die Erfindung die Aufgabe, aus einem elektronischen Speicherbaustein der eingangs genannten Art und einer Füllstandsüberwachungsschaltung eine Speicherbausteinanordnung zu schaffen, bei der die Füllstandsüberwachungsschaltung eine exakte und rasche Erfassung der Speicherbelegung ermöglicht.

Diese Aufgabe wird erfindungsgemäß dadurch gelöst, daß die Füllstandsüberwachungsschaltung eine Auswerteeinheit aufweist, die periodisch den Zählerstand der Zähleinrichtung abfragt, und daß die Speicherlogik des elektronischen Speicherbausteins nach Beendigung eines Auslesevorgangs einer Zelle ein Quittier-Speichersignal erzeugt, das der Zähleinrichtung der Füllstandsüberwachungsschaltung zugeführt wird, deren Zählerstand durch das von der Speicherlogik erzeugte Quittierimpuls-Speichersignal dekrementiert wird.

Aus EP 0 419 958 A2 und EP 0 310 173 A1 ist es an sich schon bekannt, Zähleinrichtungen zu verwenden, um Zellen definierter Bit-Länge eines Datenstroms zu erfassen. Die Zielsetzung dabei ist aber eine andere, nämlich die Erfassung der Übertragungsgeschwindigkeit und deren Vergleich mit vorgegebenen Werten. Die Auswertung ist damit grundsätzlich anders.

Durch die erfindungsgemäßen Maßnahmen wird in besonders vorteilhafter Art und Weise einfach und schnell eine exakte Ermittlung des Füllstandes des Speichers eines elektronischen Speicherbausteins erreicht. Die erfindungsgemäß enthaltene Füllstandsüberwachungsschaltung zeichnet sich nun besonders dadurch aus, daß sie besonders schnell anspricht und bereits nach einigen gespeicherten Zellen effizient arbeitet. Man ist daher nicht - wie bisher - gezwungen, zu warten, daß ein Speicher halb voll ist, um mit einer füllstandsadaptiven Auslesesequenz zu beginnen. Dies hat den Vorteil, daß nur eine minimale Verzögerung der Datenströme auftritt.

Eine vorteilhafte Weiterbildung der Erindung sieht vor, daß die Auswerteeinheit in Abhängigkeit vom ermittelten Zählerstand ein Auslesesignal erzeugt, das der Speicherlogik des elektronischen Speicherbausteins zugeführt wird, welche darauf den Auslesevorgang einer Zelle initiiert. Durch die erfindungsgemäß enthaltene Füllstandsüberwachungsschaltung ist eine füllstandsadaptive Auslesesequenz mehrerer parallel angeordneter elektronischer Speicherbausteine, welche bedingt durch das ihnen zugeführte unterschiedliche Datenaufkommen, einen unterschiedlichen Füllstand aufweisen, möglich. Die erfindungsgemäßen Maßnahmen bewirken außerdem in vorteilhafter Art und Weise, daß die Speicher der elektronischen Speicherbausteine optimal dimensioniert werden können, wodurch sich die Herstellungskosten der Speicherbausteine deutlich reduzieren.

Eine vorteilhafte Weiterbildung der Erfindung sieht vor, daß in den Signalweg des Zählimpuls-Speichersignals und des Quittier-Speichersignals jeweils eine der Zähleinrichtung vorgeschaltete Speichersignal-Trenneinrichtung geschaltet ist, die eine zeitliche Auflösung eines sich mit dem Quittier-Signal überlappenden Zählimpuls-Speichersignals durchführt. Durch diese Maßnahme wird in vorteilhafter Weise erreicht, daß eine einwandfreie Funktion der Zähleinrichtung und somit der Füllstandseinrichtung auch dann gewährleistet ist, wenn gleichzeitig ein den Zählerstand der Zähleinrichtung inkrementierendes Zählimpuls-Speichersignal und eine diesen dekrementierendes Quittier-Speichersignal auftreten.

Weitere vorteilhafte Weiterbildungen der Erfindung ergeben sich aus den Unteransprüchen.

Weitere Einzelheiten der Erfindung sind dem Ausführungsbeispiel zu entnehmen, das im folgenden anhand der Zeichnungen beschrieben wird. Es zeigen:
- Figur 1: ein Ausführungsbeispiel;
- Figur 2: den Signalverlauf in einer Speichersignal-Trenneinrichtung des Ausführungsbeispiels.

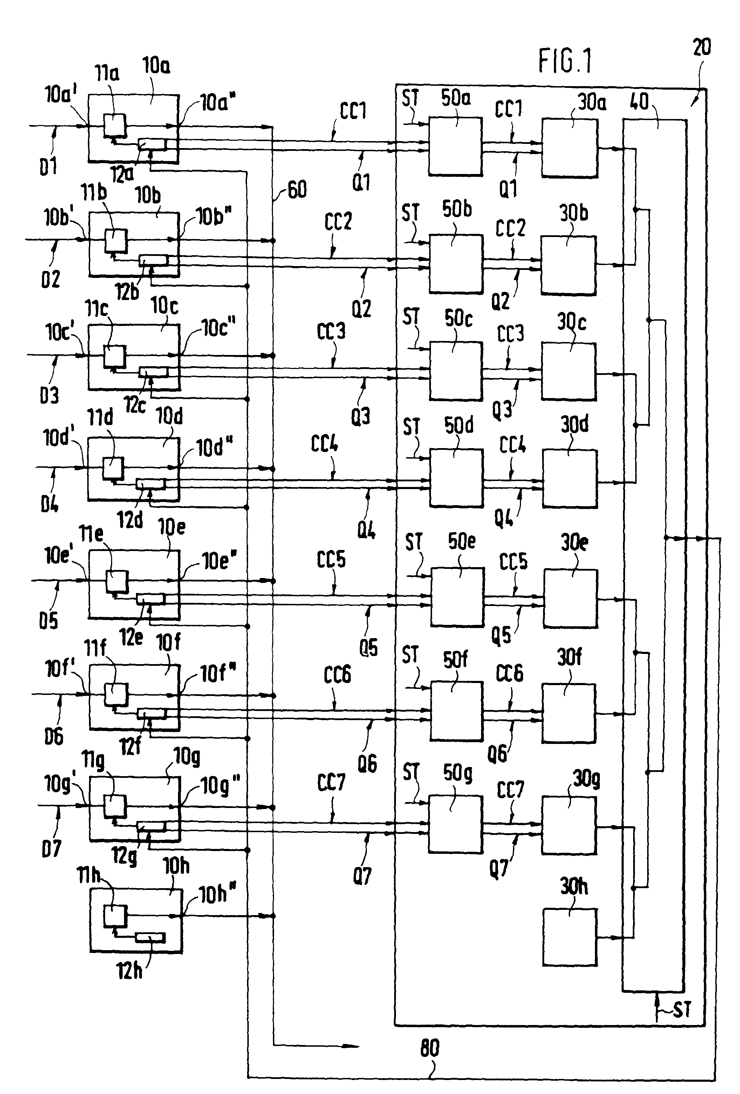

Das in der Figur 1 dargestellte Ausführungsbeispiel weist sieben identisch aufgebaute elektronische Speicherbausteine 10a-10g auf, deren Dateneingang 10a'-10g' jeweils ein kontinuierlicher Datenstrom D1-D7 zugeführt wird. Die einzelnen Bits eines jeden Datenstromes D1-D7 werden in an sich bekannter Art und Weise in einem als FIFO oder als Dual-Port-RAM ausgeführten Speicher 11a-11g des elektronischen Speicherbausteins 10a-10g byteweise abgespeichert. Dieses Abspeichern sowie das Auslesen der gespeicherten Daten wird von einer in jedem elektronischen Speicherbaustein 10a-10g vorhandenen Speicherlogik 12a-12g gesteuert. Diese Speicherlogiken 12a-12g erzeugen außerdem noch Speichersignale, deren Funktion weiter unten noch eingehend erläutert werden wird.

Die in der Figur 1 dargestellte Schaltung weist außerdem noch einen elektronischen Speicherbaustein 10h mit einem Leerzellen-Speicher 11h und mit einer zugeordneten Speicherlogik 12h auf, in dem sog. Leerzellen abgespeichert werden. Diese sollen immer dann ausgelesen werden, wenn die Speicher 11a-11g der elektronischen Speicherbausteine 10a-10g leer sind oder deren Belegung einen definierten Wert nicht übersteigt.

Die den einzelnen Speicherbausteinen 10a-10g zugeführten Datenströme D1-D7 weisen im allgemeinen eine unterschiedliche Bitrate auf, so daß die Speicher 11a-11g der elektronischen Speicherbausteine 10a-10g nicht gleichmäßig gefüllt werden. Der durch das unterschiedliche Datenaufkommen der einzelnen Datenströme D1-D7 bedingte unterschiedliche Füllstand der einzelnen Speicher 11a-11g der elektronischen Speicherbausteine 10a-10g erfordert nun eine füllstandsadaptive Auslesesequenz, damit ein Überlaufen der Speicher 11a-11g verhindert wird. Der einfacheren Beschreibung halber wird im folgenden angenommen, daß der Speicher 11a des elektronischen Speicherbauteils 10a zum betrachteten Zeitpunkt den höchsten Füllstand aufweist.

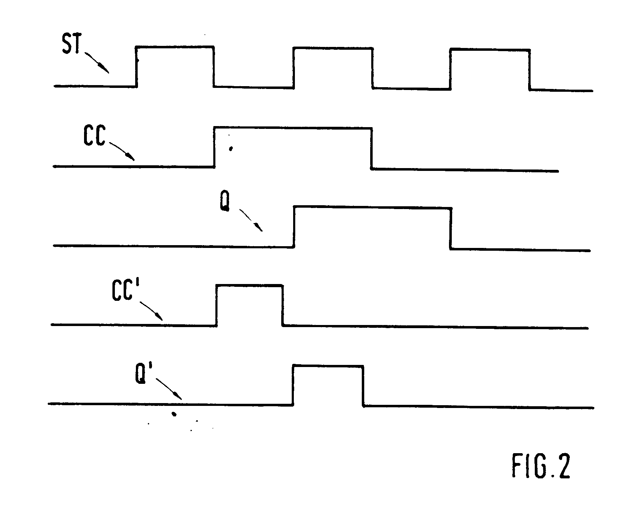

Hierzu dient die Füllstandsüberwachungsschaltung 20, welche die Belegung der einzelnen Speicher 11a-11g periodisch überwacht: Die Speicherlogiken 12a-12g eines jeden elektronischen Speicherbausteins 10a-10g erzeugt hierzu ein Zählimpuls-Speichersignal CC1-CC7, welches der Füllstandsüberwachungsschaltung 20 zugeleitet wird. Dieses Zählimpuls-Speichersignal CC1-CC7 wird immer dann erzeugt, wenn in einem der Speicher 11a-11g eine definierte Anzahl von Bytes eingeschrieben wurde, so daß die Speicherlogik 12a-12g des betreffenden elektronischen Speicherbausteins 10a-10g daraus einen Zelle definierter Bit-Länge bilden kann. Beispielsweise wird bei einer der CCITT-Empfehlung I.361 entsprechenden ATM-Kommunikationsanlage, bei der jeweils 48 Datenbytes zu einer Zelle zusammengefaßt werden, immer dann das Zählimpuls-Speichersignal CC1-CC7 erzeugt, wenn die o.g. Byte-Anzahl in einem Speicher der Speicher 11a-11g der elektronischen Speicherbausteine 10a-10g abgespeichert wurde. Gemäß der eingangs getroffenen Annahme erzeugt also hier die Speicherlogik 12a des elektronischen Speicherbausteins 10a das Zählimpuls-Speichersignal CC1, welches vorzugsweise durch einen Rechteckimpuls repräsentiert wird, der die Dauer eines die Signalverarbeitung des Ausführungsbeispiels steuerenden Systemtaktes ST (vgl. dazu Fig. 2) aufweist.

Die einzelnen Zählimpuls-Speichersignale CC1-CC7 werden jeweils über eine weiter unten noch näher beschriebene Speichersignal-Trenneinrichtung 50a-50g zu je einer zugeordneten Zähleinrichtung 30a-30g der Füllstandsüberwachungsschaltung 20 geleitet und inkrementieren deren Zählerstand. Die Füllstandsüberwachungsschaltung 20 weist außerdem noch eine weitere Zähleinrichtung 30h auf, welche funktionell dem Leerzellen-Speicher 11h zugeordnet ist. Diese weitere Zähleinrichtung 30h - deren Funktion weiter unten beschrieben ist - weist einen fixierten Zählerstand auf, welcher beliebig voreinstellbar ist.

Eine Auswerteeinrichtung 40 der Füllstandsüberwachungsschaltung 20 ruft periodisch mit einem geteilten Systemtakt ST die aktuellen Zählerstände der Zähleinrichtungen 30a-30g und der weiteren Zähleinrichtung 30h ab und vergleicht die Zählerstände der einzelnen Zähleinrichtungen der elektronischen Speicherbausteine 10a-10h untereinander.

Hierzu ist vorgesehen, daß die Auswerteeinrichtung 40 in einem ersten Schritt paarweise den jeweils höheren Zählerstand der ersten und der zweiten 30a und 30b bzw. der dritten und der vierten 30c und 30d bzw. der fünften und der sechsten 30e und 30f bzw. der siebenten und der weiteren Zähleinrichtung 30g und 30h ermittelt. Der aus diesem paarweisen Vergleich ermittelte jeweils höhere Wert der beiden ersten miteinander verglichenen Zählerstände wird in einem zweiten Schritt wiederum mit dem jeweils höheren Zählerstand der dritten und der vierten Zähleinrichtung 30c und 30d verglichen, etc. verglichen, so daß bei acht Zähleinrichtungen nach drei derartigen Schritten derjenige elektronische Speicherbaustein (10a) ermittelt ist, dessen Speicher (11a) den höchsten Füllstand aufweist. Die Auswerteeinrichtung 40 der Füllstandsüberwachungseinrichtung 20 erzeugt daraufhin ein codiert die Adresse des auszulesenden Speichers 11a enthaltendes Auslesesignal, welches über einen Datenbus 80 der Steuerlogik 12a des elektronischen Speicherbausteins 10a zugeführt wird. Die durch das Auslesesignal adressierte Speicherlogik 12a initiiert daraufhin den Auslesevorgang einer Zelle aus dem Speicher 11a.

Nachdem das letzte Byte der auszulesenden Zelle, die über eine Datenleitung 60 zu einer in Figur 1 nicht gezeigten Vermittlungsstelle 60 geleitet wird, über einen entsprechenden Ausleseausgang 10a''-10h'' (hier: 10a'') den Speicher (hier 10a) verlassen hat, erzeugt die Speicherlogik 12a ein Quittier-Speichersignal Q1-Q7 (hier: Q1), welches über die Speichersignal-Trenneinrichtung 50a-50g derjenigen Zähleinheit (30a) der Auswerteeinrichtung 40 zugeführt wird, die dem ausgelesenen Speicher (10a) zugeordnet ist. Das jeweils von der Speicherlogik 12a-12g erzeugte Quittier-Speichersignal Q1-Q7 bewirkt, daß der Zählerstand der entsprechenden Zähleinrichtung 30a-30g (hier: 30a) der Füllstandsüberwachungsschaltung 20 dekrementiert wird.

Von Vorteil hierbei ist, daß der Zählerstand der weiteren Zähleinrichtung 30h auf einen definierten Wert voreingestellt ist. Wie aus der oben beschriebenen Ermittlung des höchsten Zählerstandes aller Zähleinrichtungen 30a-30h leicht ersichtlich ist, bewirkt die Vorgabe einer fixen Zählerstandes der weiteren Zähleinrichtung 30h, daß der Auslesevorgang der Zellen aus den Speichern 11a-11g erst dann beginnt, wenn deren Füllstand den voreingestellten Wert des Zählerstandes des weiteren Zählers übersteigt. Derart ist er leicht möglich, den dem Datenstrom mit der höchsten Bitrate beim füllstandsadaptieren, sequentiellen Auslesevorgang zu priorisieren.

Alternativ oder ergänzend hierzu ist es möglich, jeder Zähleinrichtung 30a-30h einen zwecks Priorisierung einen unterschiedlichen Startwert des Zählerstandes zu geben.

Im darauffolgenden Takt des die Signalverarbeitung der elektronischen Speicherbausteins 10a-10h und der Füllstandsüberwachungseinrichtung 20 steuernden geteilten Systemtaktes ST erfolgt, wie oben beschrieben, der nächste Auslesevorgang.

Wichtig sind noch die bereits oben genannten Speichersignal-Trennungseinrichtungen 50a-50g, welche jeweils zwischen einem elektronischen Speicherbaustein 10a-10g und der dazugehörigen Zähleinrichtung 30a-30g der Füllstandsüberwachungsschaltung 20 im Signalweg der Zählimpuls- und der Quittier-Speichersignale CC1-CC7 und Q1-Q7 geschaltet sind. Diese Speichersignal-Trenneinrichtungen 50a-50g dienen dazu, die von der Speicherlogik 12a-12g eines jeden Speicherbausteines erzeugten Speichersignale CC1-CC7 bzw. Q1-Q7 - welche unterschiedlichen Zählrichtungen der Zähleinheit entsprechen - zeitlich aufzulösen, so daß eine einwandfreie Funktion der Zähleinrichtungen 30a-30g der Füllstandsüberwachungseinrichtung 20 gewährleistet ist.

Die Funktion einer der Speichersignal-Trenneinrichtungen 50a-50g wird anhand der Figur 2 erläutert. In die erste Zeile ist der Verlauf des die Signalverarbeitung des Ausführungsbeispiels steuernden Systemtaktes ST dargestellt. Die zweite Zeile der Figur 2 zeigt das von einer der Speicherlogiken 12a-12g die elektronischen Speicherbausteine 10a-10g erzeugten Zählimpuls-Speichersignal, welches allgemein mit CC bezeichnet wird. Der zeitliche Verlauf des Zählimpuls-Speichersignals CC ist dabei derart, daß dieses nur dann für die Dauer einer Periode des Systemtaktes ST den logischen Wert "1" annimmt, wenn bereits soviel Bits des dem jeweiligen Speicher 11a-11g zugeführten Datenstroms D1-D7 abgespeichert wurden, so daß die Speicherlogik 12a-12g des jeweiligen elektronischen Speicherbausteins 10a-10g daraus eine neue Zelle definierter Bit-Länge bilden kann.

Da die Speicher 11a-11g der elektronischen Speicherbausteine 10a-10g sowohl gleichzeitig ein Schreiben als auch ein Auslesen einer Zelle ermöglichen, ist es denkbar, daß - wie in Zeile 3 der Fig. 2 dargestellt - im selben Takt des Systemtakts ST von einer Speicherlogik 12a-12g sowohl ein Zählimpuls CC als auch ein Quittiersignal Q erzeugt wird. Wird die zugeordnete Zähleinrichtung 30a-30g mit einer derartigen Signalkonstellation angesteuert, d.h. treten im selben Systemtakt ST gleichzeitig ein die Zähleinrichtung 30a-30g inkrementierendes Zählimpuls-Speichersignal CC und ein diese dekrementierendes Quittier-Speichersignal Q auf, ist bei derartigen überlappenden Speichersignalen ein Zählfehler der Zähleinrichtung 30a-30g nicht ausgeschlossen.

Es ist deshalb vorgesehen, daß in der Speichersignal-Trenneinrichtung 50a-50g die beiden Speichersignale CC und Q zeitlich separiert werden, so daß dieser Überlappungszustand aufgehoben wird. Hierzu wird - wie aus der vierten Zeile der Figur 2 ersichtlich ist - der einen Zählimpuls repräsentierende logische "1"-Zustand des Zählimpuls-Speichersignals CC derart verkürzt, daß er etwas weniger als eine halbe Periode des Systemstaktes ST entspricht (CC'). Dementsprechend wird - wie aus der fünften Zeile der Figur 2 ersichtlich ist - der "1"-Zustand des Quittier-Speichersignals Q verkürzt (Q1). Durch diese Maßnahme ist es besonders einfach möglich, eine einwandfreie Funktion der Zähleinrichtungen 30a-30g auch bei zeitlich überlappenden Speichersignalen zu erreichen.

## Patentansprüche

1. Speicherbausteinanordnung mit einem elektronischen Speicherbaustein (10a-10g; 10h), dessen Speicher (11a-11g) ein Datenstrom (D1-D7) zugeführt wird, und der eine Speicherlogik (12a-12g) aufweist, welche die im Speicher (11a-11g) abgespeicherten Bits des Datenstroms (D1-D7) zu Zellen definierter Bit-Länge zusammenfaßt, die an einem Ausleseausgang (10a''-10g'') des elektronischen Speicherbausteins (10a-10g) abgreifbar sind, wobei die Speicherlogik (12a-12g) des elektronischen Speicherbausteins (10a-10g) für jede vollständige Zelle definierter Bit-Länge ein Zählimpuls-Speichersignal (CC1-CC7; CC) erzeugt, das einer Zähleinrichtung (30a-30g) einer Füllstandsüberwachungsschaltung (20) zugeführt wird, deren Zählerstand durch das von der Speicherlogik (12a-12g) erzeugte Zählimpuls-Speichersignal (CC1-CC7; CC) inkrementiert wird, **dadurch gekennzeichnet**, daß die Füllstandsüberwachungsschaltung (20) eine Auswerteeinheit (40) aufweist, die periodisch den Zählerstand der Zähleinrichtung (30a-30g) abfragt und daß die Speicherlogik (12a-12g) des elektronischen Speicherbausteins nach Beendigung eines Auslesevorgangs einer Zelle ein Quittier-Speichersignal (Q1-Q7; Q) erzeugt, das der Zähleinrichtung (30a-30g) der Füllstandsüberwachungsschaltung (20) zugeführt wird, deren Zählerstand durch das von der Speicherlogik erzeugte Quittierimpuls-Speichersignal dekrementiert wird.

2. Speicherbausteinanordnung nach Anspruch 1, dadurch gekennzeichnet, daß die Auswerteeinheit (40) in Abhängigkeit vom ermittelten Zählerstand ein Auslesesignal erzeugt, das der Speicherlogik (12a-12h) eines der elektronischen Speicherbausteine (10a-10h) zugeführt wird, welche darauf den Auslesevorgang einer Zelle initiiert.

3. Speicherbausteinanordnung nach Anspruch 1, dadurch gekennzeichnet, daß in den Signalweg der Speichersignale (CC1-CC7; Q1-Q7) und vor die Zähleinrichtung (30a-30g) der Auswerteeinrichtung (40) eine Speichersignal-Trenneinrichtung (50a-50g) geschaltet ist, die eine zeitliche Auflösung eines sich mit dem Quittier-Speichersignal (Q1-Q7;Q) überlappenden Zählimpuls-Speichersignals (CC1-CC7;CC) durchführt.

4. Speicherbausteinanordnung nach Anspruch 3, dadurch gekennzeichnet, daß die Speichersignal-Trenneinrichtung (50a-50g) die Impulsdauer des Zählimpuls-Speichersignals (CC1-CC7;CC) und des Quittier-Speichersignals (Q1-Q7;Q) auf eine Zeitspanne verkürzt, welche weniger als die halbe Periodendauer eines die Signalverarbeitung steuernden Systemtakts (ST) beträgt.

5. Speicherbausteinanordnung nach einem der Ansprüche 1 bis 4 mit mehreren parallel angeordneten elektronischen Speicherbausteinen (10a-10g), an deren Dateneingang (10a'-10g') jeweils ein Datenstrom (D1-D7) anliegt, dadurch gekennzeichnet, daß jede Speicherlogik (12a-12g) eines jeden elektronischen Speicherbausteins (10a-10g) mit je einer Zähleinrichtung (30a-30g) der Füllstandsüberwachungsschaltung (20) verbunden ist, daß die Auswerteeinrichtung (40) periodisch den Zählerstand aller Zählereinrichtungen (30a-30g) abfragt und die Zähleinrichtung (30a) mit dem höchsten Zählerstand ermittelt.

6. Speicherbausteinanordnung nach Anspruch 5, dadurch gekennzeichnet, daß die Auswerteeinrichtung (40) ein Auslesesignal erzeugt, daß codiert die Adresse des den höchsten Füllstand aufweisenden elektronischen Speicherbausteins (10a) enthält.

7. Speicherbausteinanordnung nach Anspruch 5, dadurch gekennzeichnet, daß die Auswerteeinrichtung (40) den höchsten Zählerstand aller Zähler (30a-30g) derart ermittelt, daß in einem ersten Schritt jeweils die Zählerstande zweier Zähleinrichtungen (30a,30b; 30c,30d; 30e,30f; 30g,30h) verglichen werden, und daß in den darauffolgenden Schritten jeweils die Zählerständer der Zähleinrichtungen verglichen werden, die im vorhergehenden paarweisen Vergleich den höheren Zählerstand aufweisen.

8. Speicherbausteinanordnung nach Anspruch 5, dadurch gekennzeichnet, daß ein elektronischer Speicherbaustein (10h) vorgesehen ist, der einen Leerzellen-Speicher (llh) aufweist, und daß die zu diesem elektronischen Speicherbaustein (10h) korrelierte weitere Zähleinrichtung (30h) der Füllstandsüberwachungsschaltung (20) einen vorbestimmten Zählerstand aufweist.

9. Speicherbausteinanordnung nach Anspruch 5, dadurch gekennzeichnet, daß mindestens eine der Zähleinrichtungen (30a-30g) einen von Null verschiedenen vorgewählten Startwert des Zählerstandes aufweist.

10. Speicherbausteinanordnung nach Anspruch 5, dadurch gekennzeichnet, daß die Auswerteeinrichtung (40) periodisch die Zähleinrichtung (30a) mit dem höchsten Zählerstand ermittelt, und daß die Auswerteeinrichtung (40) der Füllstandsüberwachungsschaltung (20) ein Auslesesignal erzeugt, das codiert die Adresse des den höchsten Füllstand aufweisenden elektronischen Speicherbausteins (10a) der Speicherbausteinanordnung enthält.

## Claims

1. Memory module arrangement having an electronic memory module (10a-10g; 10h) whose memory (11a-11g) is supplied with a data stream (D1-D7) and which has a memory logic (12a-12g) which combines the bits of the data stream (D1-D7) stored in the memory (11a-11g) into cells of defined bit length which can be tapped off at a read-out output (10a''-10g'') of the electronic memory module (10a-10g), the memory logic (12a-12g) of the electronic memory module (10a-10g) generating, for every complete cell of defined bit length, a counting pulse memory signal (CC1-CC7; CC) which is supplied to a counting device (30a-30g) of an occupancy-level-monitoring circuit (20) whose counter reading is incremented by the counting pulse memory signal (CC1-CC7; CC) generated by the memory logic (12a-12g), characterized in that the occupancy-level-monitoring circuit (20) has an evaluation unit (40) which periodically senses the counter reading of the counting device (30a-30g) and in that the memory logic (12a-12g) of the electronic memory module generates, after completing a read-out procedure for a cell, an acknowledgement memory signal (Q1-Q7; Q) which is supplied to the counting device (30a-30g) of the occupancy-level-monitoring device (20), the counter reading of the counting device (30a-30g) being decremented by the acknowledgement pulse memory signal generated by the memory logic.

2. Memory module arrangement according to Claim 1, characterized in that the evaluation unit (40) generates, as a junction of the counter reading found, a read-out signal which is supplied to the memory logic (12a-12h) of one of the electronic memory modules (10a-10h), which then initiates the read-out procedure for a cell.

3. Memory module arrangement according to Claim 1, characterized in that there is connected in the signal path of the memory signals (CC1-CC7; Q1-Q7) and upstream of the counting device (30a-30g) of the evaluation device (40) a memory signal separating device (50a-50g) which performs a time resolution of a counting pulse memory signals (CC1-CC7; CC) which overlaps the acknowledgement memory signal (Q1-Q7; Q).

4. Memory module arrangement according to Claim 3, characterized in that the memory signal separating device (50a-50g) shortens the pulse duration of the counting pulse memory signal (CC1-CC7; CC) and of the acknowledgement memory signal (Q1-Q7; Q) to a time interval which is less than half the cycle duration of a system clock (ST) which controls the signal processing.

5. Memory module arrangement according to one of Claims 1 to 4, having a plurality of electronic memory modules (10a-10g) which are disposed in parallel and to each data input (10a'-10g') of which a data stream (D1-D7) is supplied, characterized in that each memory logic (12a-12g) of every electronic memory module (10a-10g) is connected to one counting device (30a-30g) in each case of the occupancy-level-monitoring circuit (20), and in that the evaluation device (40) periodically senses the counter reading of all the counting devices (30a-30g) and determines the counting device (30a) having the highest counter reading.

6. Memory module arrangement according to Claim 5, characterized in that the evaluation device (40) generates a read-out signal which contains the address in coded form of the electronic memory module (10a) having the highest occupancy.

7. Memory module arrangement according to Claim 5, characterized in that the evaluation device (40) determines the highest counter reading of all the counters (30a-30g) in such a way that, in a first step, the respective counter readings of two counting devices (30a, 30b; 30c, 30d; 30e, 30f; 30g, 30h) are compared and that, in the subsequent steps, the respective counter readings of the counting devices are compared which have the higher counter reading in the preceding pair-wise comparison.

8. Memory module arrangement according to Claim 5, characterized in that an electronic memory module (10h) is provided which has an empty-cell memory (11h) and in that the further counting device (30h), correlated with said electronic memory module (10h), of the occupancy-level-monitoring circuit (20) has a predetermined counter reading.

9. Memory module arrangement according to Claim 5, characterized in that at least one of the counting devices (30a-30g) has a preselected starting value of the counter reading which differs from zero.

10. Memory module arrangement according to Claim 5, characterized in that the evaluation device (40) periodically determines the counting device (30a) having the highest counter reading, and in that the evaluation device (40) of the occupancy-level-monitoring circuit (20) generates a read-out signal which contains the address in coded form of that electronic memory module (10a) of the memory module arrangement that has the highest occupancy.

## Revendications

1. Configuration d'un composant de mémoire comprenant un composant de mémoire électronique (10a-10g ; 10h), un flux de données (D1-D7) étant acheminé vers la mémoire (11a-11g) dudit composant électronique, qui comporte une logique de mémoire (12a-12g), qui regroupe les bits du flux de données (D1-D7), stockés dans la mémoire (11a-11g), sous forme de cellules avec des longueurs de bits définies, qui peuvent être captées à la sortie de lecture (10a"-10g") du composant de mémoire électronique (10a-10g), la logique de mémoire (12a-12g) du composant de mémoire électronique (10a-10g) émettant pour chaque cellule complète d'une longueur de bits définie un signal mémoire d'une impulsion de comptage (CC1-CC7 ; CC), lequel signal est acheminé vers un compteur (30a-30g) d'un circuit de surveillance du niveau d'occupation de la mémoire (20), dont la position du compteur est incrémentée par le signal mémoire d'une impulsion de comptage (CC1-CC7 ; CC) émis par la logique de mémoire (12a-12g), **caractérisée en ce que** le circuit de surveillance du niveau d'occupation (20) comporte une unité d'analyse (40), qui interroge périodiquement la position du compteur (30a-30g) et en ce que la logique de mémoire (12a-12g) du composant de mémoire électronique émet un signal mémorie de confirmation (Q1-Q7 ; Q) à la fin du processus de lecture d'une cellule de mémoire, lequel signal est acheminé vers le compteur (30a-30g) du circuit de surveillance du niveau d'occupation (20), dont la position est décrémentée par le signal mémoire de l'impulsion de confirmation émis par la logique de mémoire.

2. Configuration d'un composant de mémoire selon la revendication 1, caractérisée en ce que l'unité d'analyse (40) émet un signal de lecture en fonction de la position du compteur déterminée, lequel signal est acheminé vers la logique de mémoire (12a-12h) de l'un des composants de mémoire électroniques (10a-10h), qui initialise ensuite le processus de lecture d'une cellule de mémoire.

3. Configuration d'un composant de mémoire selon la revendication 1, caractérisée en ce que, dans le trajet des signaux mémoire (CC1-CC7 ; Q1-Q7) et en amont du compteur (30a-30g) de l'unité d'analyse (40), est monté un dispositif de séparation du signal mémoire (50a-50g), qui exécute une décomposition en fonction du temps d'un signal mémoire d'une impulsion de comptage (CC1-CC7 ; CC) qui chevauche le signal mémoire de confirmation (Q1-Q7 ; Q).

4. Configuration d'un composant de mémoire selon la revendication 3, caractérisée en ce que le dispositif de séparation du signal mémoire (50a-50g) réduit la durée d'impulsion du signal mémoire d'une impulsion de comptage (CC1-CC7 ; CC) et du signal mémoire de confirmation (Q1-Q7 ; Q) à un espace de temps qui est inférieur à une demi-période du cycle du système (ST) qui commande le traitement du signal.

5. Configuration d'un composant de mémoire selon l'une quelconque des revendications 1 à 4, comprenant plusieurs composants de mémoire électroniques (10a-10g), montés en parallèle et dont chaque entrée de données (10a'-10g') capte un flux de données (D1-D7), caractérisée en ce que chaque logique de mémoire (12a-12g) de chaque composant de mémoire électronique (10a-10g) est reliée à un compteur (30a-30g) du circuit de surveillance du niveau d'occupation (20), en ce que l'unité d'analyse (40) interroge périodiquement la position de tous les compteurs (30a-30g) et détermine le compteur (30a) présentant la position la plus élevée.

6. Configuration d'un composant de mémoire selon la revendication 5, caractérisée en ce que le dispositif d'analyse (40) émet un signal de lecture, qui contient l'adresse sous forme codée du composant de mémoire électronique (10a) présentant le niveau d'occupation le plus élevé.

7. Configuration d'un composant de mémoire selon la revendication 5, caractérisée en ce que l'unité d'analyse (40) détermine la position de compteur la plus élevée parmi tous les compteurs (30a-30g), de manière à comparer au cours d'une première étape chaque position de compteur de deux compteurs (30a, 30b ; 30c, 30d ; 30e, 30f ; 30g, 30h), et de manière à comparer au cours de chaque étape consécutive la position des compteurs qui au cours de la comparaison par couple précédente présentaient la position de compteur la plus élevée.

8. Configuration d'un composant de mémoire selon la revendication 5, caractérisée en ce qu'il est prévu de monter un composant de mémoire électronique (10h) qui comporte une mémoire avec des cellules à vider (11h), et en ce que le compteur supplémentaire (30h) du circuit de surveillance du niveau d'occupation (20), correspondant à ce composant de mémoire électronique (10h), comporte une position de compteur définie par une valeur par défaut.

9. Configuration d'un composant de mémoire selon la revendication 5, caractérisée en ce qu'au moins l'un des compteurs (30a-30g) présente une valeur de départ de la position du compteur, présélectionnée et différente de zéro.

10. Configuration d'un composant de mémoire selon la revendication 5, caractérisée en ce que l'unité d'analyse (40) détermine périodiquement le compteur (30a) avec la position la plus élevée, et en ce que l'unité d'analyse (40) du circuit de surveillance du niveau d'occupation (20) émet un signal de lecture qui contient sous forme codée l'adresse du composant de mémoire électronique (10a) présentant le niveau d'occupation le plus élevé de la configuration du composant de mémoire.
